Europäisches Patentamt

European Patent Office

Office européen des brevets

(11) Veröffentlichungsnummer: **0 369 048**

**A1**

## (12) EUROPÄISCHE PATENTANMELDUNG

(21) Anmeldenummer: 88119041.7

(22) Anmeldetag: 15.11.88

(51) Int. Cl.⁵: **H03K 17/08**

(43) Veröffentlichungstag der Anmeldung:
23.05.90 Patentblatt 90/21

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Leipold, Ludwig, Dipl.-Ing.**
**Strassberger Strasse 125**
**D-8000 München 40(DE)**
Erfinder: **Sander, Rainald, Dipl.-Phys.**
**Karl-Theodor-Strasse 25**
**D-8000 München 40(DE)**
Erfinder: **Tihanyi, Jenö, Dr.-Ing.**
**Windeckstrassse 1 d**
**D-8000 München 70(DE)**
Erfinder: **Weber, Roland, Dipl.-Ing.**
**Ursulastrasse 5**
**D-8000 München 40(DE)**
Erfinder: **Nance, Paul, MSE**
**1116 Castleton**
**Sunnyvale 94087(US)**

(54) Schaltungsanordnung zur Laststromregelung in einem Leistungs-MOSFET.

(57) Bei einem Leistungs-MOSFET (1) mit sourceseitiger Last (2) ist eine Strombegrenzung über die Erfassung der Spannung zwischen Gate und Masse nicht möglich. Zwischen Gate und Source ist daher die Drain-Sourcestrecke eines zweiten FET (5) eingeschaltet, der eine definierte Einsatzspannung hat. Der Gateanschluß es zweiten FET (5) liegt im leitenden Zustand des Leistungs-MOSFET über einen dritten MOSFET (6) auf dem Drainpotential des Leistungs-MOSFET. Wird die Drain-Source-Spannung des Leistungs-MOSFET größer als die Einsatzspannung des zweiten FET (5), wird dieser leitend und regelt die Gate-Source-Spannung des Leistungs-FET zurück

FIG 1

## Schaltungsanordnung zur Laststromregelung in einem Leistungs-MOSFET

Die Erfindung bezieht sich auf eine Schaltungsanordnung zur Regelung des Laststroms eines Leistungs-MOSFET, dem sourceseitig eine Last in Reihe geschaltet ist.

Es ist im allgemeinen erwünscht, den Drainstrom vom Leistungs-MOSFET zu regeln oder zu begrenzen, so daß dieser im Überlastungsfall nicht zerstört wird. Da dem Leistungs-MOSFET sourceseitig eine Last in Reihe geschaltet ist, ist es nicht möglich, die Regelung über die Spannung zwischen dem Gate des FET und Masse vorzunehmen.

Der Erfindung liegt das Ziel zugrunde, eine Schaltungsanordnung der erwähnten Gattung so weiterzubilden, daß eine Regelung des durch den Leistungs-MOSFET fließenden Stroms mit einfachen Mitteln möglich wird.

Dieses Ziel wird durch folgende Merkmale erreicht:

a) Zwischen dem Gate-und dem Sourceanschluß des Leistungs-MOSFET liegt die Source-Drainstrecke eines zweiten MOSFET,

b) die Einsatzspannung des zweiten MOSFET ist größer als die bei Nennstrom am Leistungs-MOSFET abfallende Drain-Sourcespannung,

c) der Gateanschluß des zweiten MOSFET ist mit dem Sourceanschluß eines dritten MOSFET verbunden, dessen Drainanschluß mit dem Drainanschluß des Leistungs-MOSFET verbunden ist,

d) der Gateanschluß des dritten MOSFET ist mit dem Gateanschluß des Leistungs-MOSFET verbunden,

e) der Gateanschluß des zweiten MOSFET ist mit einem Anschluß einer Stromquelle verbunden, deren anderer Anschluß auf festem Potential liegt.

Die Erfindung macht von dem z. B. aus der DE-OS 30 34 927 bekannten Prinzip Gebrauch, die am Leistungs-MOSFET abfallende Drain-Sourcespannung als Meßgröße für den Drainstrom zu benutzen. Bei der bekannten Schaltungsanordnung liegt zwischen Gateanschluß und Sourceanschluß des Leistungs-MOSFET ein Bipolartransistor, der im Fall einer Überlastung des Leistungs-MOSFET eingeschaltet wird und die Gate-Sourcekapazität des Leistungs-MOSFET entlädt.

Der Bipolartransistor sperrt erst wieder, wenn die Steuerspannung für den Leistungs-MOSFET unterbrochen wird. Der Leistungs-MOSFET wird hier im Überlastfall gesperrt. Eine Regelung oder Begrenzung des Drainstroms findet nicht statt.

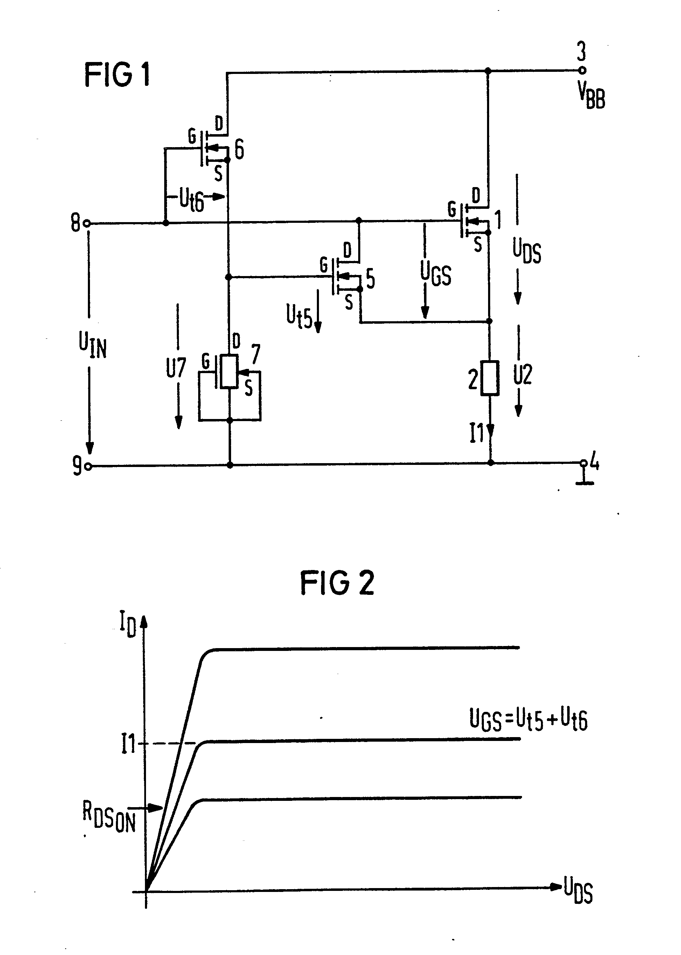

Die Erfindung wird anhand eines Ausführungsbeispiels in Verbindung mit den FIG 1 und 2 näher erläutert. Es zeigen

FIG 1 die Schaltungsanordnung gemäß der Erfindung und

FIG 2 das Kennlinienfeld Drainstrom/Drain-Sourcespannung eines Leistungs-MOSFET.

Die Schaltungsanordnung nach FIG 1 enthält einen Leistungs-MOSFET 1, dem sourceseitig eine Last 2 in Reihe geschaltet ist. Die Reihenschaltung liegt an zwei Ausgangsklemmen 3, 4, an denen die Versorgungsspannung $V_{BB}$ angeschlossen ist. Zwischen dem Gateanschluß G und dem Sourceanschluß S von 1 liegt die Drain-Sourcestrecke eines zweiten MOSFET 5. Der Reihenschaltung aus 1 und 2 ist die Reihenschaltung aus einem dritten MOSFET 6 und einer Stromquelle 7 parallel geschaltet. Dabei ist der Drainanschluß von 6 mit dem Drainanschluß von 1 verbunden. Der Verbindungspunkt zwischen MOSFET 6 und Stromquelle 7 ist mit dem Gateanschluß G des zweiten MOSFET 5 verbunden. Der andere Anschluß der Stromquelle 7 ist mit der Ausgangsklemme 4 verbunden, die auf festem Potential, beispielsweise auf Massepotential liegt. Die Gateanschlüsse G der MOSFET 6 und 1 sind mit einer Eingangsklemme 8 verbunden. Eine andere Eingangsklemme ist mit 9 bezeichnet und liegt z. B. auf Massepotential.

Zur Erläuterung der Wirkungsweise wird angenommen, daß eine Eingangsspannung $U_{IN}$ an die Eingangsklemmen 8, 9 gelegt wird.

Erreicht diese die Einsatzspannung des Leistungs-MOSFET 1 so beginnt 1 zu leiten, da sein Sourceanschluß zunächst noch auf Massepotential liegt. Der Gateanschluß des MOSFET 5 liegt über die Stromquelle ebenfalls an Massepotential. Der MOSFET 5 bleibt daher gesperrt. Mit steigender Eingangsspannung $U_{IN}$ wird der Leistungs-MOSFET 1 weiter geöffnet, wobei sein Sourcepotential dem Gatepotential folgt. Das Gatepotential des MOSFET 5 (Spannung U7) über der Stromquelle 7 folgt ebenfalls der Eingangsspannung $U_{IN}$ und ist um die Einsatzspannung $U_{t6}$ des MOSFET 6 geringer als diese. Erreicht die Eingangsspannung einen Wert, der größer als die Summe aus der Versorgungsspannung $V_{BB}$ und der Einsatzspannung $U_{t6}$ ist, so ist der MOSFET 6 voll eingeschaltet und am Gate von 5 liegt das Potential der Klemme 3, d. h. Versorgungsspannung $V_{BB}$, an.

Am Eingang des Leistungs-MOSFET 1 liegt jetzt eine Spannung $U_{GS}$, die sich aus der Differenz der Eingangsspannung $U_{IN}$ und der an der Last 2 abfallenden Spannung U2 ergibt. Die Spannung $U_{GS}$ ist derart bemessen, daß sie den Leistungs-MOSFET 1 völlig leitend steuert. In diesem Zustand fließt ein Strom I1 durch 1, der dem Nennstrom entspricht. Die Spannung $U_{GS}$ ist zweckmäßigerweise so bemessen, daß der Arbeitspunkt für I1 am oberen Ende des linearen Bereichs der $I_D/U_{DS}$-Kennlinie nach FIG 2 liegt. Im Falle einer Überlastung oder eines Kurzschlusses der Last 2 steigt der Transistorstrom I1 an. Damit wächst auch die am Leistungs-MOSFET 1 abfallende Spannung $U_{DS}$. Wird diese Spannung größer als die Einsatzspannung $U_{t5}$ des MOSFET 5, so beginnt 5 zu leiten. Die Steuerspannung $U_{GS}$ von 1 wird so lange reduziert, bis die Spannung $U_{DS}$ wieder gleich $U_{t5}$ ist. Der Reduzierung der Spannung $U_{GS}$ entspricht einer Reduzierung des Drainstroms $I_D$. Die Höhe der Steuerspannung $U_{GS}$ wird auf die der Summe der Einsatzspannungen $U_{t5}$ + $U_{t6}$ der MOSFET 5 und 6 begrenzt.

Die Summe der Einsatzspannungen $U_{t5}$ + $U_{t6}$ wird zweckmäßigerweise so gewählt, daß sich beim Nennstrom I1 der o.g. Arbeitspunkt im Kennlinienfeld (FIG 2) einstellt, der am Knickpunkt zwischen dem linearen Bereich und dem Sättigungsbereich liegt. Durch die Wahl der Einsatzspannung $U_{t5}$ kann derjenige Wert der Spannung $U_{DS}$ an 1 bestimmt werden, bei der die Abregelung der Steuerspannung einsetzen soll. Eine Änderung der Einsatzspannung $U_{t6}$ kann neben der Änderung der Designparameter des MOSFET 6 durch eine Änderung der Stromquelle 7 erreicht werden, da $U_{t6}$ eine Funktion des Drainstroms von 6 ist.

Bezugszeichenliste

1     = Leistungs-MOSFET
2     = Last
3, 4     = Ausgangsklemmen
5, 6     = MOSFET
7     = Stromquelle
8, 9     = Eingangsklemme

**Ansprüche**

1. Schaltungsanordnung zur Regelung des Laststroms eines Leistungs-MOSFET, dem sourceseitig eine Last in Reihe geschaltet ist, **gekennzeichnet durch**
die Merkmale:

a) Zwischen dem Gate- und dem Sourceanschluß des Leistungs-MOSFET (1) liegt die Source-Drainstrecke eines zweiten MOSFET (5),

b) die Einsatzspannung des zweiten MOSFET ist größer als die bei Nennstrom am Leistungs-MOSFET abfallende Drain-Source-Spannung,

c) der Gateanschluß des zweiten MOSFET (5) ist mit dem Sourceanschluß eines dritten MOSFET (6) verbunden, dessen Drainanschluß mit dem Drainanschluß des Leistungs-MOSFET verbunden ist,

d) der Gateanschluß des dritten MOSFET ist mit dem Gateanschluß des Leistungs-MOSFET verbunden

e) der Gateanschluß des zweiten MOSFET ist mit einem Anschluß einer Stromquelle (7) verbunden, deren anderer Anschluß auf festem Potential liegt.

2. Schaltungsanordnung nach Anspruch 1, **dadurch gekennzeichnet,** daß die Summe der Einsatzspannungen vom zweiten und dritten MOSFET derart gewählt ist, daß sich für den Leistungs-MOSFET für einen vorgegebenen Nennstrom ein Arbeitspunkt am oberen Ende des linearen Bereichs des Kennlinienfeldes $I_D/U_{DS}$ einstellt.

FIG 1

FIG 2

Europäisches Patentamt

**EUROPÄISCHER RECHERCHENBERICHT**

Nummer der Anmeldung

EP 88 11 9041

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-3 445 340 (STAIBER)<br>* Seite 3, letzter Absatz; Figuren 2,4 * | 1 | H 03 K 17/08 |
| Y | | 2 | |
| | --- | | |
| Y | ELECTRONICS & WIRELESS WORLD, Band 80, Nr. 1464, August 1974, Seiten 299-301; T.JONES: "Choose the right f.e.t."<br>* Seite 299, linke Spalte, Absatz 1 *<br>----- | 2 | |

| | |
|---|---|
| | **RECHERCHIERTE SACHGEBIETE (Int. Cl.5)**<br><br>H 03 K<br>G 05 F |

Der vorliegende Recherchenbericht wurde für alle Patentansprüche erstellt

| Recherchenort | Abschlußdatum der Recherche | Prüfer |
|---|---|---|
| DEN HAAG | 13-07-1989 | CANTARELLI R.J.H. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.................................................................................
& : Mitglied der gleichen Patentfamilie, übereinstimmendes Dokument